(19) Europäisches Patentamt
European Patent Office
Office européen des brevets

(11) **EP 4 786 077 A1**

(12) **EUROPEAN PATENT APPLICATION**

(43) Date of publication:
05.08.2026 Bulletin 2026/32

(21) Application number: 25218439.5

(22) Date of filing: 25.11.2025

(51) International Patent Classification (IPC):
$B22F\ 10/368^{(2021.01)}$    $B22F\ 10/38^{(2021.01)}$
$B22F\ 10/80^{(2021.01)}$    $G06N\ 20/10^{(2019.01)}$
$B33Y\ 10/00^{(2015.01)}$    $G06N\ 20/00^{(2019.01)}$
$G06N\ 3/08^{(2023.01)}$    $B33Y\ 30/00^{(2015.01)}$
$B33Y\ 50/00^{(2015.01)}$

(52) Cooperative Patent Classification (CPC):
B33Y 50/02; B22F 10/368; B22F 10/38;
B22F 10/80; B33Y 10/00; B33Y 30/00; B33Y 50/00;
G06N 3/08; G06N 20/00; G06N 20/10; B22F 12/90;
G06F 30/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 25.11.2024 US 202418958383

(71) Applicant: RTX Corporation
Farmington, CT 06032 (US)

(72) Inventors:
• LIU, Jingfu
eden Prairie (US)
• LYNCH, Matthew E.
Canton (US)
• MONDAL, Sudeepta
Manchester (US)
• SARKAR, SOUMALYA
Glastonbury (US)
• NORMAN, Joshua M.
South Windsor (US)

(74) Representative: Dehns
10 Old Bailey
London EC4M 7NG (GB)

(54) **MODELING AND DETERMINING LIFE EXPECTANCY OF PRODUCT OBTAINED BY METAL ADDITIVE MANUFACTURING PROCESSES**

(57) An additive manufacturing machine (100) forms a part (130) utilizing additive manufacturing and with a plurality of layers. A controller (140) includes processing circuitry and a memory (144), and is operable for receiving design information about a proposed part (130) to be manufactured utilizing additive manufacturing, and also receives proposed process parameters for the additive manufacturing machine (100). The controller (140) is operable to predict a temperature at each of a plurality of layers that will be found in the proposed part (130), and identify a temperature history for a plurality of the layers including identifying the time to solidify for at least one of the plurality of layers, and determine a derivative of a change in temperature of the at least one of the plurality of layers over time and predicting grain structure utilizing the derivative. The controller (140) is operable to determine an expected life based upon the predicted grain structure. A method is also disclosed.

FIG.1

## Description

### TECHNICAL FIELD

This application relates to a method and apparatus for modeling and lifing a part formed by a metal additive manufacturing process.

### BACKGROUND OF THE INVENTION

Additive manufacturing is becoming more and more prevalent in manufacturing metal parts. However, it is challenging to evaluate the expected life of an additively manufactured part. Additive manufacturing processes could be said to be stochastic. Current methods of predicting the expected life of an additively manufactured part typically take a long time. Further, they require high performance computing platforms.

In addition, the modeling tends to be limited to small representative volume elements, and does not apply to macro-level or complex shapes.

### SUMMARY OF THE INVENTION

In a featured embodiment, an additive manufacturing apparatus includes a chamber, an additive manufacturing machine; and the additive manufacturing machine is operable to form a part utilizing additive manufacturing and with a plurality of layers. A controller includes processing circuitry and a memory, and is operable for receiving design information about a proposed part to be manufactured utilizing additive manufacturing, and also receives proposed process parameters for the additive manufacturing machine. The controller is operable to predict a temperature at each of a plurality of layers that will be found in the proposed part, and identify a temperature history for a plurality of the layers including identifying the time to solidify for at least one of the plurality of layers, and determine a derivative of a change in temperature of the at least one of the plurality of layers over time and predicting grain structure utilizing the derivative. The controller is operable to determine an expected life based upon the predicted grain structure.

In another embodiment according to the previous embodiment, the additive manufacturing process parameters include at least one process parameters.

In another embodiment according to any of the previous embodiments, the at least one process parameter includes at least one of a power, a speed, a thickness of the layers, a spot size, or hatch spacing.

In another embodiment according to any of the previous embodiments, the controller is operable to generate an image of grain structure in the at least one of the plurality of layers, and compare the generated image to historic images to determine whether the generated image is likely accurate.

In another embodiment according to any of the previous embodiments, the generated image is utilized to quantify a grain size of at least one element in the part, and a machine learning system determines an average grain size, with the grain size quantification utilized to evaluate the accuracy of the determined grain size.

In another embodiment according to any of the previous embodiments, a final grain structure is determined with a first quantity multiplied by the quantified grain size, and added to the determined grain size multiplied by one minus the first quantity, with the first quantity being selected to give relative weight to the determined and quantified grain size information.

In another embodiment according to any of the previous embodiments, the cooling rate for the at least one of the layers includes all of the layers and is compared to a grain morphology map to provide a three dimensional reconstruction of a grain structure within the part.

In another embodiment according to any of the previous embodiments, the change in temperature for the at least one of the layers is used with a machine learning model to predict the grain structure.

In another embodiment according to any of the previous embodiments, the determined expected life is compared to a minimum life and updates at least one of the design information and process parameter and repeats the steps if the determined expected life does not meet the minimum life.

In another embodiment according to any of the previous embodiments, if the determined life of the part meets the minimum life, then the part is manufactured utilizing the additive manufacturing processes.

In another featured embodiment, a method of modeling and predicting a life for an additive manufactured part includes the steps of receiving design information about a proposed part to be manufactured utilizing additive manufacturing, and also receiving proposed process parameters for the additive manufacturing, predicting the temperature at each of a plurality of layers that will be found in the proposed part, and identifying a temperature history for a plurality of the layers including identifying the time to solidify for at least one of the plurality of layers, determining a derivative of a change in a temperature of the at least one of the plurality of layers over time and predicting grain structure in the part utilizing the derivative and determining an expected life based upon the predicted grain structure.

In another embodiment according to any of the previous embodiments, the additive manufacturing process parameters include at least one process parameters.

In another embodiment according to any of the previous embodiments, at least one process parameter includes at least one of a power, a speed, a thickness of the layers, a spot side, or hatch spacing.

In another embodiment according to any of the previous embodiments, an image of grain structure in the at least one of the plurality of layers is generated, and compared to historic images to determine whether the generated image is likely accurate.

In another embodiment according to any of the previous embodiments, the generated image is utilized to quantify a grain size of at least one element in the part, and determining, using machine learning, an average grain size, with the grain size quantification utilized to evaluate the accuracy of the determined grain size.

In another embodiment according to any of the previous embodiments, a final grain structure is determined with a first quantity multiplied by the quantified grain size, and added to the determined grain size multiplied by one minus the first quantity, with the first quantity being selected to give relative weight to the determined and quantified grain size information.

In another embodiment according to any of the previous embodiments, the cooling rate for the at least one of the layers includes all of the layers and is compared to a grain morphology map to provide a three dimensional reconstruction of a grain structure within the part.

In another embodiment according to any of the previous embodiments, the change in temperature for the at least one of the layers is used with a machine learning model to predict the grain structure.

In another embodiment according to any of the previous embodiments, the determined expected life is compared to a minimum life and updating at least one of the design information and the process parameters and repeating the steps if the determined expected life does not meet the minimum life.

In another embodiment according to any of the previous embodiments, if the determined life of the part meets the minimum life, then the part is manufactured utilizing the additive manufacturing processes.

The present disclosure may include any one or more of the individual features disclosed above and/or below alone or in any combination thereof.

These and other features of the present invention can be best understood from the following specification and drawings, the following of which is a brief description.

## BRIEF DESCRIPTION OF THE DRAWINGS

Figure 1 schematically shows an additive manufacturing system.

Figure 2 is an overview of the main features of this disclosure.

Figure 3A shows complex temperature contours from a cross-section of an additive manufacturing component through six layers of buildup.

Figure 3B shows a temperature history at a first layer in an additive manufacturing part.

Figure 3C shows a temperature history at a later layer.

Figure 3D shows a temperature history of the last solidification cycle of one of the layers such as shown in Figure 3C.

Figure 4 shows a further step that can be taken with the Figure 3D data.

Figure 5 shows another feature that can be used with the Figure 3D data.

Figure 6 is a flow chart for an overall method.

## DETAILED DESCRIPTION

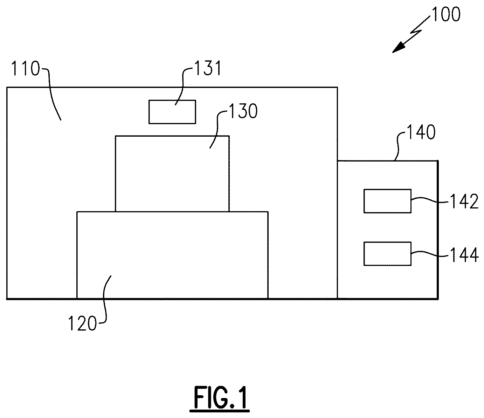

Figure 1 schematically illustrates an additive manufacturing machine 100, such as a laser powder bed fusion additive manufacturing machine. In alternate examples, the powder bed fusion machine can be an electron beam powder bed fusion machine. Other types of additive manufacturing machines may also be used. The exemplary additive manufacturing machine 100 includes a manufacturing chamber 110 with a platform 120 upon which a part 130 is additively manufactured. A controller 140 is connected to the chamber 110 and is operable to control an additive manufacturing system 131 according to any known additive manufacturing controls. As known, system 131 will deposit and then heat a fluent material in layers to form part 130.

Included within the controller 140 is one or more processors 142 operable to collectively receive and interpret input operations to define a sequence of the additive manufacturing, and memory 144 operable to store software instructions (e.g., modules) for directing the controller 140 and for analyzing received operations. As utilized herein "operations" refers to instructions specifying operational conditions and sequences for one or more step in an additive manufacturing process. The controller 140 can, in some examples, include user interface devices such as a keyboard and view screen. In alternative examples, the controller 140 can include a wireless or wired communication apparatus for communicating with a remote user input device such as a PC.

In an example operation, a part design is provided by a user to the controller 140. The part design is typically a 3D modeling file, such as an STL file. The controller 140 includes internal software modules operable to convert the STL file into an additive manufacturing process, and the additive manufacturing machine 100 executes the process to create the part.

Flaws such as keyhole or lack of fusion can occur either as a result of non-optimal machine parameters or randomly as a result of stochastic variation of uncontrolled and uncontrollable build parameters during additive manufacturing operation.

Included within the controller 140 is a module for determining grain structure, and optimize the performance parameters of the additive manufacturing system 100 accordingly. The module may determine if the grain structure is desirable or undesirable.

In order to determine if an operation is likely to generate stochastic flaws, the controller 140 includes an analysis tool that receives a part design and a set of additive manufacturing parameters and determines the chance that the operation will generate flaws, and how many flaws are likely to develop.

The controller 140 may include one or more computer processors, memory, storage means, network devices, input and/or output devices, and/or interfaces. The computing devices may be operable to execute one or more software programs. The computing devices may be operable to communicate with one or more networks established by one or more computing devices. The memory may include UVPROM, EEPROM, FLASH, RAM, ROM, DVD, CD, a hard drive, or other computer readable medium which may store data and/or the functionality of this description. The computing device(s) may be collectively operable to execute any of the functionality disclosed herein. The computing devices may be a desktop computer, laptop computer, smart phone, tablet, or any other computer device. Input devices may include a keyboard, mouse, touchscreen, etc. The output devices may include a monitor, speakers, printers, etc. Each of the computing devices may include one or more processors coupled to memory. The computing devices may be coupled to each other by one or more connections. The connection may be a wired and/or wireless connection. The connections may be established over one or more networks and/or other computing systems.

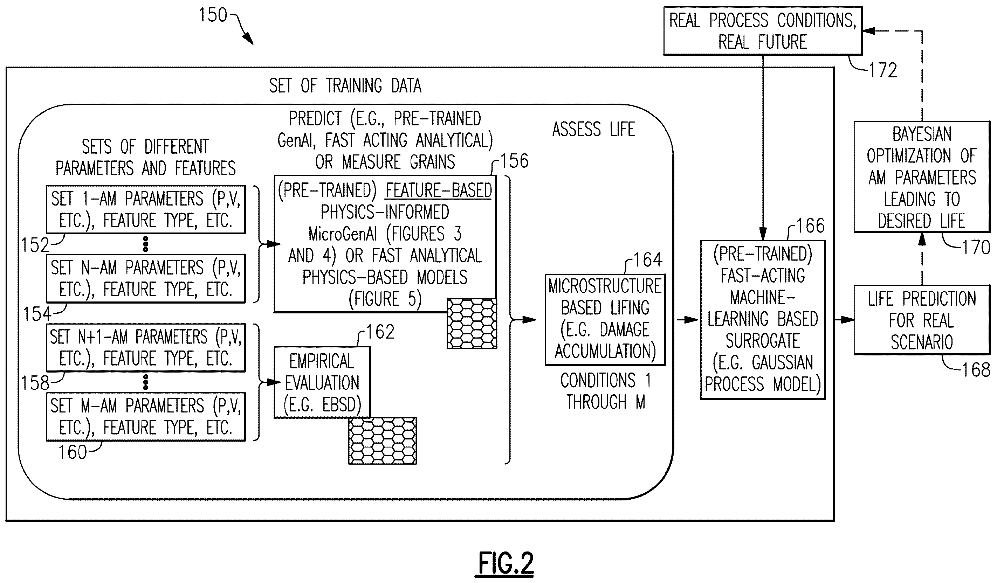

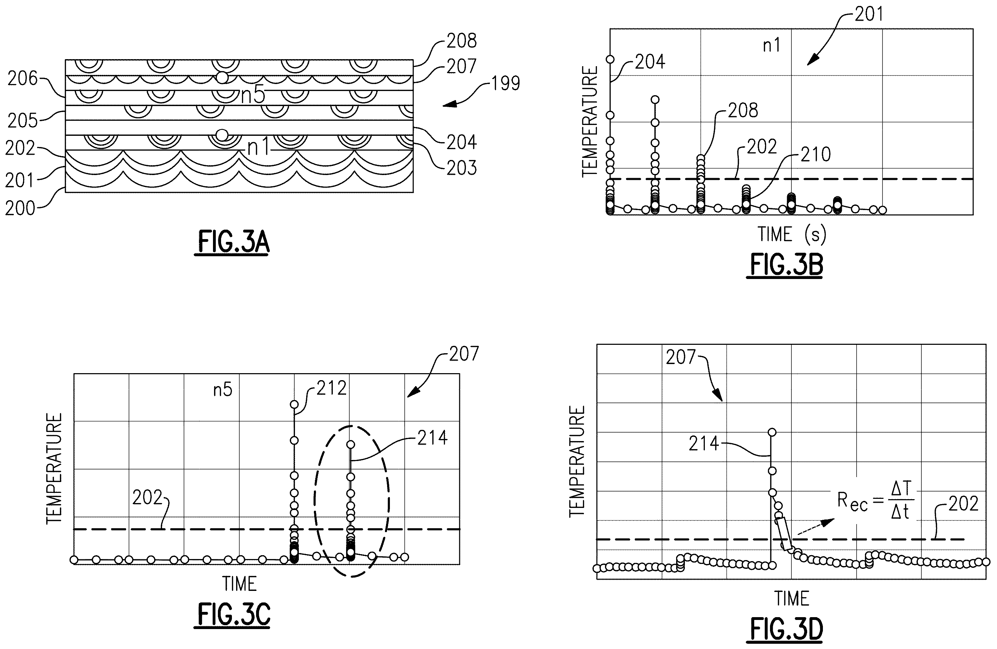

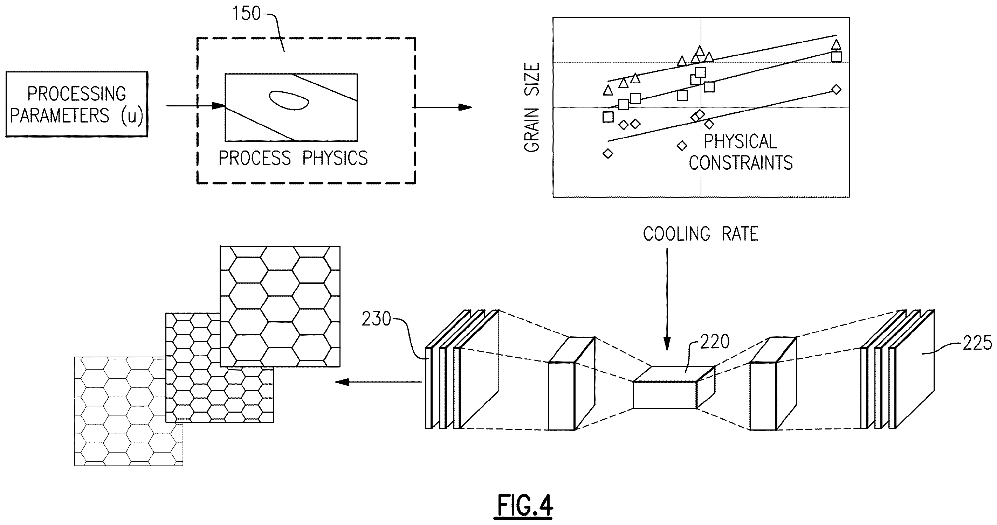

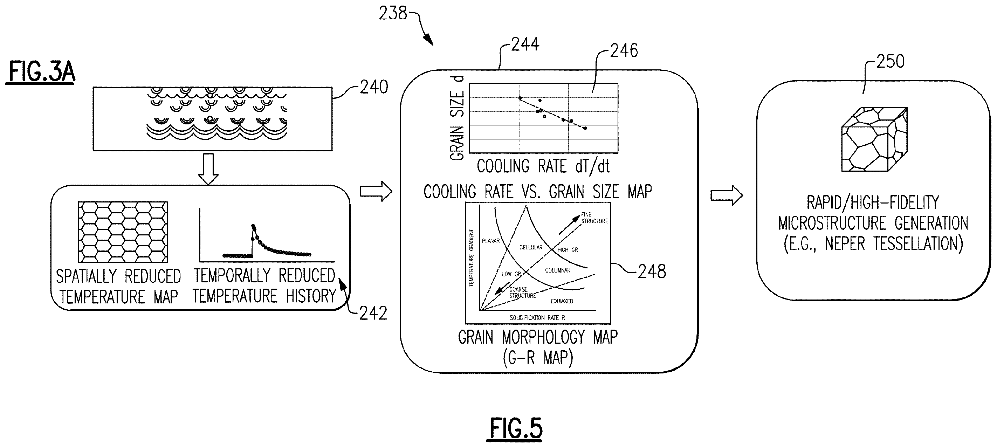

Figure 2 is an overview of a system 150 for determining an expected life of a part based upon an initial part design and additive manufacturing parameters. The parameters and part design from sets 1-N (152/154) pass into a fast acting system (e.g., model) 156 for determining grain features. In one embodiment, the system 156 may be a physics-informed generative artificial intelligence system trained on a plurality of past empirical data (see Figures 3A-3E and 4). In another embodiment, the system 156 may rely upon an analytical physics-based model (see Figure 5).

Another method 162 looks at a set of parameters and N+1-M (158/160) which also includes additive manufacturing process parameters and design features. An empirical evaluation of the grain structure is determined by system 162.

The additive manufacturing process parameters may include at least one of key process parameters, such as power, a speed, a thickness of the layers, a spot size, or hatch spacing (distance between the center lines of two laser passes in additive manufacturing.)

The system 156 is trained on a plurality of data set 1-N, but the empirical model 162 receives data set N+1-M. That is, the model 156 is not trained on all of the data from the model 162. In examples, say 75% of the data in the empirical evaluation route 162 trains the model 156, while 25% is utilized to test as described above.

Now, the model 156 is operable to determine a grain structure by methods disclosed below which is outside of the sets 1-N. In particular, a prediction is made utilizing the parameters and design of set 1-N. The empirical model 162 is then used to check the accuracy of the prediction of the model 156. Assuming the prediction is accurate, then a microstructure based lifing system is applied in step 166.

In one application, Sentient Sciences Component Life Prediction Software may be utilized to predict the life. Of course, other systems may be utilized. The predicted life is then passed through a pretrained fast-acting machine learning based surrogate (e.g., Gaussian Process model). A life prediction is then determined at step 168.

There may be an iterative process of optimizing the additive manufacturing parameters or the part design at 170. At step 172 real process conditions and real features are evaluated, and the system returns to the step 166.

Figure 3A shows a part 199 formed of a plurality of additive manufacturing layers 200, 201, 202, 203, 204, 205, 206, 207 and 208. The temperature contour across each of the layers is illustrated. As additional layers are added on top of earlier layers they reheat the lower layers.

Figure 3B shows a temperature history of the layer 200. It is initially formed at an early time to have a temperature profile 204. The temperature profile of point n1 cools through the melting line 202 and is subsequently reheated and re-melted, e.g. by temperature profile 208. By the fourth layer the temperature profile 210 does not increase the temperature at point n1 above the melting line 202.

In contrast, the step 207 at point n5 has an initial temperature contour 212, and then a temperature profile 214 after the layer 208 has been deposited.

This is the last layer to be impacted by a subsequent layer. Applicant has recognized that it is the most informative layer of the grain structure at point n5. Thus, this embodiment of this disclosure focusses on layer 207 to make a determination of the grain structure.

Now, as shown in Figure 3D, a derivative of the change in temperature over time Rec is determined.

While the next to last layer may be the most instructive, this application extends to one of the last 10% of layers, and in embodiments the last 5%, and in further embodiments the last 1%.

Figure 4 is a way of implementing the model 156 in Figure 2. In particular, it is a method based on machine learning to generate synthetic grain structures. The output from the system 150 is passed into a system 220 which looks at the training data 225 to reach predictions of the layers. The most general case would be a point in the middle of the part, with many layers deposited above. This is best depicted by point n1 in Figure 3A. This is then utilized in the Figure 2 overview to reach a predicted life.

In embodiments, the predictive microstructure may be determined based upon the following formula:

$$L = \lambda L_{data} + (1 - \lambda)L_{phys}$$

$L_{phys}$ is from step 164.

There are two Machine learning models in Figure 2.

1) Model (e.g., step) 156: this is a surrogate model from "AM process parameter --> AM microstructure"
2) Model (e.g., step) 166: this is a surrogate model from "AM microstructure --> life" In the STEP 156: we used GenAI that uses the equation:

$$L = \lambda L_{data} + (1 - \lambda)L_{phys}$$

where "L_data" means "loss from empirical data." the source of "L_data" is not shown in the Figure 2. It is calculated from empirical data (similar to 162, but previously calculated). "L_phys" means: loss from physics, it is from 152 and 154).

In the STEP 166: the above formula for determining predictive microstructure is not used, but the model is trained based on all the data from 164 (a combination of empirical data and simulated data).

Figure 5 is a way of implementing the model 156 in Figure 2. In particular, it is a semi-analytical method (alternative to the machine learning based method in Figure 4). The full temperature data across the entire part is taken at 240. This is then reduced into the temperature history of each of the layers at 242. At step 244 the cooling rate 246 is compared to a grain morphology map 248. Such maps are known, and can predict the grain structure at each point on a part based upon the cooling rate.

Then at step 250, the overall grain structure across the part is predicted. This can then be utilized with the lifing system as set forth above.

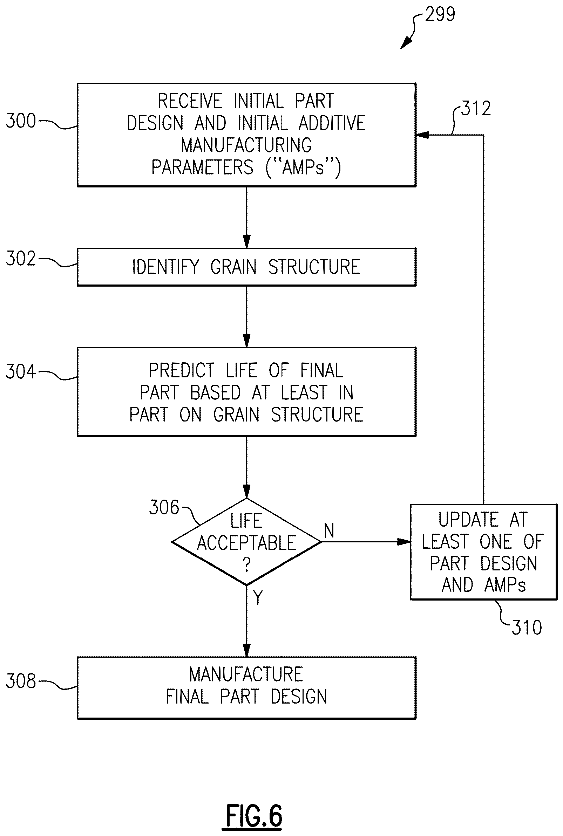

A flow chart 299 according to this disclosure is shown in Figure 6. At step 300, a controller receives initial part design and initial additive manufacturing parameters. At step 302, the grain structure is identified utilizing any of the methods described herein.

Then, the expected life of a final part based at least in part on the grain structure is predicted.

At step 306, the system asks if that life is acceptable.

If it is, then the final part may be manufactured at step 308. If it is not acceptable then at step 310, the controller updates at least one of the part design and the additive manufacturing parameters, and returns at step 312 to step 300.

The disclosed embodiment provides rapid prediction of microstructure and useful life of additively manufactured components within hours on a standard workstation. It allows local deployment to portable workstations and is compatible across different additive manufacturing machines and models. It also enables very quick real-time processing optimization on the fly to improve part durability. It applies to a wide range of products that can leverage new advance manufacturing processes and design.

Parts that may be manufactured could be gas turbine engine components, bearing housings, heat exchangers, hypersonic aerostructure shells, etc.

The alloys utilized with the additive manufacturing systems may include nickel, aluminum, steel, titanium or other known additive manufacturing materials.

Although embodiments of this disclosure have been shown, a worker of ordinary skill in this art would recognize that modifications would come within the scope of this disclosure. For that reason, the following claims should be studied to determine the true scope and content of this disclosure.

**Claims**

1. An additive manufacturing apparatus including:

   a chamber;
   an additive manufacturing machine; and
   said additive manufacturing machine being operable to form a part utilizing additive manufacturing and with a plurality of layers;
   a controller including processing circuitry and a memory, and operable for receiving design information about a proposed part to be manufactured utilizing additive manufacturing, and also receiving proposed process parameters for the additive manufacturing machine;
   the controller operable to predict a temperature at each of a plurality of layers that will be found in the proposed part, and identify a temperature history for a plurality of the layers including identifying the time to solidify for at least one of the plurality of layers, and determine a derivative of a change in temperature of the at least one of the plurality of layers over time and predicting grain structure utilizing the derivative; and
   the controller operable to determine an expected life based upon the predicted grain structure.

2. The apparatus as set forth in claim 1, wherein the additive manufacturing process parameters include at least one process parameters, optionally wherein the at least one process parameter includes at least one of a power, a speed, a thickness of the layers, a spot size, or hatch spacing.

3. The apparatus as set forth in any preceding claim, wherein the controller is operable to generate an image of grain structure in the at least one of the plurality of layers, and compare the generated image to historic images to determine whether the generated image is likely accurate.

4. The apparatus as set forth in claim 3, wherein the generated image is utilized to quantify a grain size of at least one element in the part, and a machine learning system determines an average grain size, with the grain size quantification utilized to evaluate the accuracy of the determined grain size.

5. The apparatus as set forth in claim 4, wherein a final grain structure is determined with a first quantity multiplied by the quantified grain size, and added to the determined grain size multiplied by one minus the first quantity, with the first quantity being selected to give relative weight to the determined and quantified grain size information.

6. The apparatus as set forth in any preceding claim, wherein the cooling rate for the at least one of the layers includes all of the layers and is compared to a grain morphology map to provide a three dimensional reconstruction of a grain structure within the part.

7. The apparatus as set forth in any preceding claim, wherein the change in temperature for the at least one of the layers is used with a machine learning model to predict the grain structure.

8. The apparatus as set forth in any preceding claim, wherein the determined expected life is compared to a minimum life and updating at least one of the design information and process parameter and repeating the steps if the determined expected life does not meet the minimum life, optionally wherein if the determined life of the part meets the minimum life, then the part is manufactured utilizing the additive manufacturing processes.

9. A method of modeling and predicting a life for an additive manufactured part comprising the steps of:

   receiving design information about a proposed part to be manufactured utilizing additive manufacturing, and also receiving proposed process parameters for the additive manufacturing; predicting the temperature at each of a plurality of layers that will be found in the proposed part, and identifying a temperature history for a plurality of the layers including identifying the time to solidify for at least one of the plurality of layers; determining a derivative of a change in a temperature of the at least one of the plurality of layers over time and predicting grain structure in the part utilizing the derivative; and determining an expected life based upon the predicted grain structure.

10. The method as set forth in claim 9, wherein the additive manufacturing process parameters include at least one process parameters, optionally wherein at least one process parameter includes at least one of a power, a speed, a thickness of the layers, a spot side, or hatch spacing.

11. The method as set forth in claim 9 or 10, wherein an image of grain structure in the at least one of the plurality of layers is generated, and compared to historic images to determine whether the generated image is likely accurate.

12. The method as set forth in claim 11, wherein the generated image is utilized to quantify a grain size of at least one element in the part, and determining, using machine learning, an average grain size, with the grain size quantification utilized to evaluate the accuracy of the determined grain size.

13. The method as set forth in claim 12, wherein a final grain structure is determined with a first quantity multiplied by the quantified grain size, and added to the determined grain size multiplied by one minus the first quantity, with the first quantity being selected to give relative weight to the determined and quantified grain size information.

14. The method as set forth in any of claims 9-13, wherein the cooling rate for the at least one of the layers includes all of the layers and is compared to a grain morphology map to provide a three dimensional reconstruction of a grain structure within the part, and/or wherein the change in temperature for the at least one of the layers is used with a machine learning model to predict the grain structure.

15. The method as set forth in any of claims 9-14, wherein the determined expected life is compared to a minimum life and updating at least one of the design information and the process parameters and repeating the steps if the determined expected life does not meet the minimum life, optionally wherein if the determined life of the part meets the minimum life, then the part is manufactured utilizing the additive manufacturing processes.

FIG.1

FIG.2

FIG.3A

FIG.3B

FIG.3C

FIG.3D

PROCESSING PARAMETERS (u)

150

PROCESS PHYSICS

GRAIN SIZE

PHYSICAL CONSTRAINTS

COOLING RATE

230

220

225

FIG.4

EP 4 786 077 A1

FIG.3A

240

SPATIALLY REDUCED TEMPERATURE MAP   TEMPORALLY REDUCED TEMPERATURE HISTORY

242

238

244   246

GRAIN SIZE d

COOLING RATE dT/dt

COOLING RATE VS. GRAIN SIZE MAP

GRAIN MORPHOLOGY MAP
(G-R MAP)

248

FIG.5

250

RAPID/HIGH-FIDELITY
MICROSTRUCTURE GENERATION
(E.G., NEPER TESSELLATION)

299

300 — RECEIVE INITIAL PART
DESIGN AND INITIAL ADDITIVE
MANUFACTURING
PARAMETERS ("AMPs")

312

302 — IDENTIFY GRAIN STRUCTURE

304 — PREDICT LIFE OF FINAL
PART BASED AT LEAST IN
PART ON GRAIN STRUCTURE

306 — LIFE
ACCEPTABLE
?

N

UPDATE AT
LEAST ONE OF
PART DESIGN
AND AMPs

310

Y

308 — MANUFACTURE
FINAL PART DESIGN

FIG.6

**EP 4 786 077 A1**

Europäisches Patentamt

European Patent Office

Office européen des brevets

**EUROPEAN SEARCH REPORT**

Application Number

EP 25 21 8439

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | America Makes - National Additive Manufacturing Innovation Institute: "TRX Webinar - 1/18/2023 - DigitalClone for Additive Manufacturing featuring Sentient Science", <br><br> , <br> 13 June 2023 (2023-06-13), XP093408862, Retrieved from the Internet: URL:https://www.youtube.com/watch?v=nMm93WmVa_Q | 1-15 | INV. <br> B22F10/368 <br> B22F10/38 <br> B22F10/80 <br> G06N20/10 <br> B33Y10/00 <br> G06N20/00 <br> G06N3/08 <br> B33Y30/00 <br> B33Y50/00 |
| Y | * screen shots at 0:06, 1:18, 7:09, 9:05, 11:17, 16:07, 17:50, 29:58, 22:25, 25:30, 29:14, 32:23, 33:54, 35:32, 40:04, 41:15 and 42:43 * <br> -& US 2022/108050 A1 (LIU ZIYE [US] ET AL) 7 April 2022 (2022-04-07) <br> * paragraphs [0003], [0008] - [0012], [0047] - [0050], [0059] - [0116], [0123] - [0127] * <br> * claims; figures * | 8,15 | |
| | ----- | | **TECHNICAL FIELDS SEARCHED (IPC)** |
| Y | DAVID FURRER ET AL: "Model-Based Material and Process Definitions for Additive Manufactured Component Design and Qualification", <br> INTEGRATING MATERIALS AND MANUFACTURING INNOVATION BIOMED CENTRAL LTD, LONDON, UK, vol. 13, no. 2, 23 May 2024 (2024-05-23), pages 488-510, XP021338618, ISSN: 2193-9764, DOI: 10.1007/S40192-024-00358-2 <br> * abstract * <br> * page 494, left-hand column, last paragraph - page 507, right-hand column, paragraph 3 * <br><br> ----- <br><br> -/-- | 8,15 | B22F <br> G06N <br> G06F |

The present search report has been drawn up for all claims

| Place of search | Date of completion of the search | Examiner |
|---|---|---|
| The Hague | 24 June 2026 | Ceulemans, Judy |

EPO FORM 1503 03.82 (P04C01)

page 1 of 2

Europäisches
Patentamt

European
Patent Office

Office européen
des brevets

**EUROPEAN SEARCH REPORT**

**Application Number**

EP 25 21 8439

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,P | GU ZHAOCHEN ET AL: "Generative network-assisted acceleration for microstructure simulation and prediction in laser-based additive manufacturing", THE INTERNATIONAL JOURNAL OF ADVANCED MANUFACTURING TECHNOLOGY SPRINGER, LONDON, vol. 137, no. 5, 1 March 2025 (2025-03-01), pages 2455-2470, XP038113434, ISSN: 0268-3768, DOI: 10.1007/S00170-025-15299-Z [retrieved on 2025-03-04] * the whole document * ----- | 3-5, 11-13 | |
| T | MICHAEL NOSONOVSKY ET AL: "Scaling of Monte Carlo simulations of grain growth in metals", MODELLING AND SIMULATION IN MATERIALS SCIENCE AND ENGINEERING. IOP PUBLISHING, BRISTOL, GB, vol. 17, no. 2, 1 March 2009 (2009-03-01), page 025004, XP020153623, ISSN: 0965-0393, DOI: 10.1088/0965-0393/17/2/025004 * 2 Kinetics of grain growth; page 3 - page 4; figure 1 * ----- | 1-15 | TECHNICAL FIELDS SEARCHED (IPC) |

The present search report has been drawn up for all claims

| Place of search | Date of completion of the search | Examiner |
|---|---|---|
| The Hague | 24 June 2026 | Ceulemans, Judy |

EPO FORM 1503 03.82 (P04C01)

page 2 of 2

## ANNEX TO THE EUROPEAN SEARCH REPORT
## ON EUROPEAN PATENT APPLICATION NO.

EP 25 21 8439

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2026

| Patent document cited in search report | Publication date | Patent family member(s) | | Publication date |
|---|---|---|---|---|
| US 2022108050 A1 | 07-04-2022 | EP | 4225561 A1 | 16-08-2023 |
| | | US | 2022108050 A1 | 07-04-2022 |
| | | US | 2022108051 A1 | 07-04-2022 |
| | | WO | 2022076451 A1 | 14-04-2022 |

EPO FORM P0459

For more details about this annex : see Official Journal of the European Patent Office, No. 12/82